# EUROPEAN PATENT APPLICATION

(11) **EP 1 526 566 A2**
(43) Date of publication of application: **27.04.2005**
(21) Application number: 04020630.2
(22) Date of filing: 31.08.2004
(51) Int. Cl.: H01L 21/20, H01L 21/02, H01L 21/8242

(54) **Method of fabricating a silicon nanocrystal, silicon nanocrystal, method for fabricating a floating gate type memory capacitor structure and floating gate type memory capacitor structure**

(30) Priority: 23.10.2003 JP 2003363411
(71) Applicant: National University Corporation Nagoya University, Nagoya-city, Aichi Pref. (JP)
(72) Inventor: Kondo, Hiroki, Nagoya City Aichi Pref. (JP); Yasuda, Yukio, Kochi Pref. 780-0870 (JP); Zaima, Shigeaki, Kasugai City Aichi Pref. (JP); Sakai, Akira, Nagoya City Aichi Pref. (JP); Sakashita, Mitsuo, Nagoya City Aichi Pref. (JP); Naito, Shinya, Toyota City Aichi Pref. (JP); Satake, Masaki, Nagoya City Aichi-Pref. (JP)
(74) Representative: von Hellfeld, Axel, Dr. Dipl.-Phys.

(57) **Abstract**

A silicon oxide layer is formed at a surface region of a silicon substrate. Then, an amorphous silicon layer 13 is formed preferably in a thickness of 1nm or below on the silicon substrate via the silicon oxide layer. Then, the amorphous silicon layer 13 is exposed to a silane gas preferably with heating the silicon substrate within a temperature range of 400-800°C to form a high density and minute silicon nanocrystal.

## Description

### BACKGROUND OF THE INVENTION

### Field of the Invention

This invention relates to a method for fabricating a silicon nanocrystal, a silicon nanocrystal, a method for fabricating a floating gate type memory capacitor structure, and a floating gate type memory capacitor structure.

### Description of the related art

In semiconductor dot memory field is required a high density nanocrystal with a number density of 1×10¹²/cm² or over and a crystal grain size of 10nm or below. In the fabrication of the nanocrystal, conventionally, the combination of a conventional film forming technique with a surface chemical treatment (chemical solution treatment) has been employed. However, the nanocrystal to satisfy the above-mentioned requirement has not been fabricated by the combination method.

In this point of view, such an attempt is made as to repeat the combination method several times to form the intended nanocrystal at multistage. With the repeated method, however, the adjacent nanocrystal dots are overlapped so that the arrangement density of the nanocrystal dots can not be uniform and the performance of the semiconductor dot memory using the nanocrystal fluctuated largely.

### SUMMERY OF THE INVENTION

It is an object of the present invention to establish a high density and minute nanocrystal and thus, to provide a practical usable semiconductor dot memory using the nanocrystal.

For achieving the above object, this invention relates to a method for fabricating a silicon nanocrystal, comprising the steps of:
forming an amorphous silicon layer on a silicon substrate, and
supplying a raw material gas onto the amorphous silicon layer to form a silicon nanocrystal.

In the present invention, an amorphous silicon layer with a minute thickness is formed on a silicon substrate, and then, a raw material gas is supplied onto the amorphous silicon layer to form a silicon nanocrystal. In this case, the amorphous silicon layer functions satisfactorily as a nucleus for the growth of the high density and minute silicon nanocrystal. As a result, the silicon nanocrystal can be rendered high density and minute so that the number density of the silicon nanocrystal can be developed to 1×10¹²/cm² and the crystal grain size of the silicon nanocrystal can be micronized to 10nm or below. Therefore, the silicon nanocrystal can be employed as a dot memory, and thus, a semiconductor dot memory made of the silicon nanocrystal can be provided.

The amorphous silicon layer can be formed directly on the silicon substrate or on the silicon substrate via a given intermediate layer. Particularly, in the fabrication of a semiconductor dot memory such as floating gate type memory capacitor, a silicon oxide layer may be formed between the silicon substrate and the semiconductor memory structure formed above the silicon substrate. In this case, the semiconductor memory structure can be electrically insulated from the silicon substrate.

In a preferred embodiment of the present invention, the thickness of the amorphous silicon layer is set to 1nm or below. In this case, the high density and minute silicon nanocrystal can be made easily.

In the formation of the silicon nanocrystal, advantageously, the silicon substrate is heated within a temperature range of 200-1000°C, preferably within a temperature range of 400-800°C. In this case, only if the amorphous silicon layer is exposed to the raw material gas, the silicon nanocrystal can be formed. That is, the silicon nanocrystal can be formed easily.

In the formation of the silicon nanocrystal through the heating of the silicon substrate, as the raw material gas can be preferably employed silane gas.

This invention also relates to a method for fabricating a floating gate type memory capacitor structure, comprising the steps of:
forming a silicon oxide layer at a surface region of a silicon substrate,
forming an amorphous silicon layer on the silicon substrate via the silicon oxide layer,
supplying a raw material gas onto the amorphous silicon layer to form a silicon nanocrystal,
oxidizing a surface region of the silicon nanocrystal,
forming an additional amorphous silicon layer so as to embed the silicon nanocrystal,
thermally oxidizing the additional amorphous silicon layer to form an additional silicon oxide layer, and
forming an electrode on the additional silicon oxide layer.

In the fabricating method of floating gate type memory capacitor structure, the memory capacitor structure is made using the high density and minute silicon nanocrystal fabricated according to the above-mentioned process. In this case, the memory capacitor can be driven satisfactorily based on the high density and minute size of the silicon nanocrystal, and can be employed as a practical semiconductor dot memory.

As mentioned above, according to the present invention can be fabricated a high density and minute nanocrystal, and can be provided a practical usable semiconductor dot memory using the nanocrystal.

### BRIEF DESCRIPTION OF THE DRAWINGS

For better understanding of the present invention, reference is made to the attached drawings, wherein
Fig. 1 is a cross sectional view illustrating one step in a fabricating method of floating gate type memory capacitor structure according to the present invention,
Fig. 2 is a cross sectional view illustrating the step after the step illustrated in Fig. 1,
Fig. 3 is a cross sectional view illustrating the step after the step illustrated in Fig. 2,
Fig. 4 is a cross sectional view illustrating the step after the step illustrated in Fig. 3,
Fig. 5 is a cross sectional view illustrating the step after the step illustrated in Fig. 4,
Fig. 6 is a cross sectional view illustrating the step after the step illustrated in Fig. 5,
Fig. 7 is a cross sectional view illustrating the step after the step illustrated in Fig. 6,
Fig. 8 is a cross sectional view illustrating the step after the step illustrated in Fig. 7,
Fig. 9 is a high resolution TEM photograph of a silicon nanocrystal according to the present invention, and
Fig. 10 is also a high resolution TEM photograph of another silicon nanocrystal according to the present invention.

### DESCRIPTION OF THE PREFERRED EMBODIMENTS

This invention will be described in detail hereinafter.

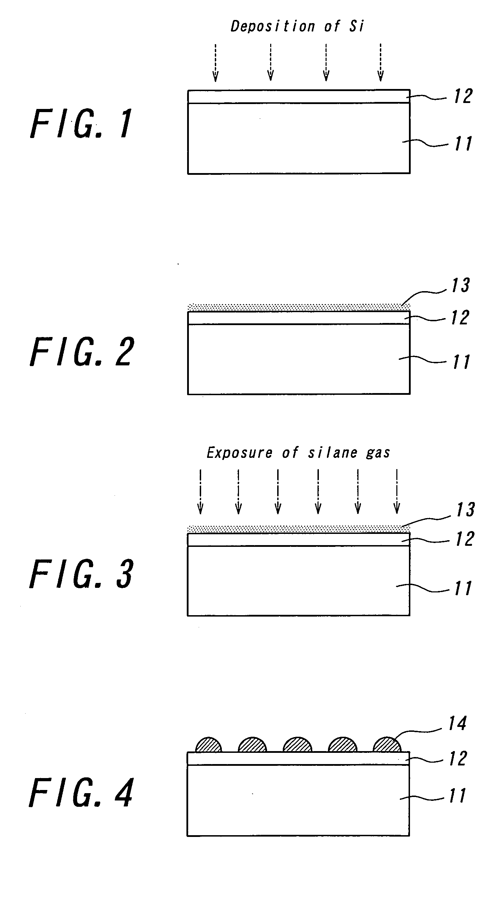

Fig. 1 is a cross sectional view illustrating one step in a fabricating method of floating gate type memory capacitor structure according to the present invention. As mentioned above, the memory capacitor fabricating method includes a fabricating method of silicon nanocrystal according to the present invention.

First of all, as illustrated in Fig. 1, a silicon substrate 11 is prepared, and an oxide silicon layer 12 is formed at the surface region of the silicon substrate 11 by means of a conventional method such as a thermal oxidizing method. Then, as illustrated in Fig. 2, an amorphous layer 13 is formed on the silicon substrate 11 via the silicon oxide layer 12 by means of a conventional method such as an electron beam vacuum deposition method. As mentioned above, the thickness of the amorphous silicon layer 13 is preferably set to 1nm or below.

In this case, the intended high density and minute silicon nanocrystal can be easily formed. The lower limit of the thickness of the amorphous silicon layer 13 is not restricted, but preferably set to 1nm.

Then, as illustrated in Fig. 3, the amorphous silicon layer 13 is exposed to a silane gas while the silicon substrate 11 is heated preferably within a temperature range of 200-1000°C, more preferably within a temperature range of 400-800°C. In this case, the silane gas is thermally decomposed on the amorphous silicon layer 13, and silicon elements created through the thermal decomposition of the silane gas are grown from the amorphous silicon layer 13 functioning as a nucleus. As a result, as illustrated in Fig. 4, a silicon nanocrystal 14 is formed from the thermally decomposed silicon elements. The number density of the silicon nanocrystal 14 can be developed to 1×10¹²/cm² or over, and the crystal grain size of the silicon nanocrystal 14 can be micronized to 10nm or below.

Herein, the crystal grain size of the silicon nanocrystal means the size of the bottom surface of each crystal grain, that is, the diameter or the length of side of the bottom surface of each crystal grain.

As the silane gas can be exemplified a monosilane gas, a disilane gas, a trisilane gas or another high ordered silane gas which are commercially available. Moreover, alkoxysilane gas where functional groups are substituted for hydrogens of a silane gas can be employed.

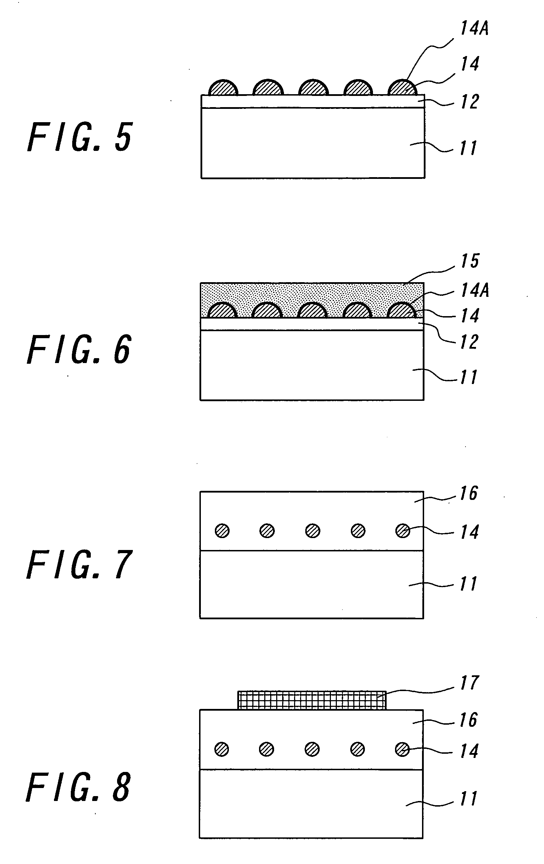

Then, as illustrated in Fig. 5, a thermal oxidizing treatment is carried out for the silicon nanocrystal 14 to form a surface oxidizing layer 14A. Then, as illustrated in Fig. 6, an additional amorphous silicon layer 15 is formed by means of a conventional method such as an electron beam vacuum deposition method so as to embed the silicon nanocrystal 14. Then, a thermal oxidizing treatment is carried out for the additional amorphous silicon layer 15 to convert the additional amorphous silicon layer 15 into an additional silicon oxide layer 16, as illustrated in Fig. 7.

In the thermal oxidizing treatment for the additional amorphous silicon layer 15, the surface region of the silicon nanocrystal 14 is also oxidized to some degree. However, the internal stress of the silicon nanocrystal 14 is increased as the surface thermal oxidization proceeds, so that the surface thermal oxidization is prohibited on some level. Therefore, the silicon nanocrystal 14 is narrowed through the surface thermal oxidization and remained. In order to utilize the silicon nanocrystal 14 as a practical dot memory of a floating gate type memory capacitor structure, the thickness of the silicon nanocrystal 14 is also set to 10nm or below.

Then, as illustrated in Fig. 8, an electrode 17 is formed on the additional silicon oxide layer 16 to form the intended floating gate type memory capacitor structure, wherein the narrowed silicon nanocrystal 14 embedded in the additional silicon oxide layer 16 functions as a memory. Moreover, since the number density of the silicon nanocrystal 14 is developed to 1x10¹²/cm² or over and the crystal grain size of the silicon nanocrystal 14 is micronized to 10nm or below, the memory capacitor structure can function as a practical semiconductor dot memory.

### Examples:

### (Example 1)

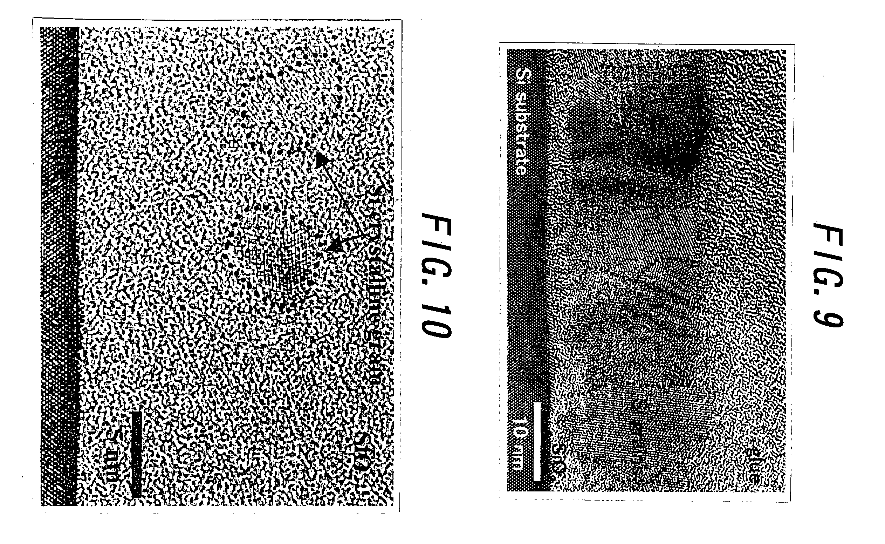

The thickness of the amorphous silicon layer 13 was set to 1nm, and the silicon substrate 11 was heated to 610°C. Then, a disilane gas (Si₂H₆) was employed as a raw material gas to form the silicon nanocrystal 14 according to the steps illustrated in Figs. 1-4. Fig. 9 is a high resolution TEM photograph of the silicon nanocrystal 14. It was turned out from Fig. 9 that the crystal grain size of the silicon nanocrystal 14 was about 10nm. Moreover, it was confirmed from the TEM observation that the arrange density and the crystal grain size of the silicon nanocrystal 14 was almost uniform.

### (Example 2)

The steps illustrated in Figs. 5-7 were carried out for the silicon nanocrystal 14 obtained in Example 1. The thickness of the additional amorphous silicon layer 15 was set to 20nm. Fig. 10 is also a high resolution TEM photograph of the silicon nanocrystal 14. It was turned out from Fig. 10 that the crystal grain size of the silicon nanocrystal 14 was narrowed to 5nm through the thermal oxidizing treatment as mentioned above. Moreover, it was confirmed from the TEM observation that the arrange density and the crystal grain size of the narrowed silicon nanocrystal 14 was almost uniform.

Although the present invention was described in detail with reference to the above examples, this invention is not limited to the above disclosure and every kind of variation and modification may be made without departing from the scope of the present invention.

## Claims

1. A method for fabricating a silicon nanocrystal, comprising the steps of:
forming an amorphous silicon layer on a silicon substrate, and
supplying a raw material gas onto said amorphous silicon layer to form a silicon nanocrystal.

2. The fabricating method as defined in claim 1, wherein a thickness of said amorphous silicon layer is set to 1nm or below.

3. The fabricating method as defined in claim 1 or 2, wherein said raw material gas is a silane gas.

4. The fabricating method as defined in any one of claims 1-3, wherein said amorphous silicon layer is exposed to said raw material gas with heating said silicon substrate to form said silicon nanocrystal.

5. The fabricating method as defined in claim 4, wherein said silicon substrate is heated within a temperature range of 200-1000°C.

6. The fabricating method as defined in any one of claims 1-5, wherein a number density of said silicon nanocrystal is 1x10¹²/cm² or over.

7. The fabricating method as defined in any one of claims 1-6, wherein a crystal grain size of said silicon nanocrystal is 10nm or below.

8. A silicon nanocrystal comprising a number density of 1x10¹²/cm² or over, wherein said silicon nanocrystal is formed on a silicon substrate.

9. The silicon nanocrystal as defined in claim 8, further comprising a crystal grain size of 10nm or below.

10. A method for fabricating a floating gate type memory capacitor structure, comprising the steps of:
forming a silicon oxide layer at a surface region of a silicon substrate,
forming an amorphous silicon layer on said silicon substrate via said silicon oxide layer,
supplying a raw material gas onto said amorphous silicon layer to form a silicon nanocrystal,
oxidizing a surface region of said silicon nanocrystal,
forming an additional amorphous silicon layer so as to embed said silicon nanocrystal,
thermally oxidizing said additional amorphous silicon layer to form an additional silicon oxide layer, and
forming an electrode on said additional silicon oxide layer.

11. The fabricating method as defined in claim 10, wherein a thickness of said amorphous silicon layer is set to 1nm or below.

12. The fabricating method as defined in claim 10 or 11, wherein said raw material gas is a silane gas.

13. The fabricating method as defined in any one of claims 10-12, wherein said amorphous silicon layer is exposed to said raw material gas with heating said silicon substrate to form said silicon nanocrystal.

14. The fabricating method as defined in claim 13, wherein said silicon substrate is heated within a temperature range of 200-1000°C.

15. The fabricating method as defined in any one of claims 10-14, wherein a number density of said silicon nanocrystal is 1×10¹²/cm² or over.

16. The fabricating method as defined in any one of claims 10-15, wherein before said oxidizing of said surface region of said silicon nanocrystal, a crystal grain size of said silicon nanocrystal is 10nm or below.

17. The fabricating method as defined in any one of claims 10-16, wherein after said thermally oxidizing of said additional silicon oxide layer, a crystal grain size of said silicon nanocrystal is 10nm or below.

18. A floating gate type memory capacitor structure comprising:
a silicon nanocrystal formed on a silicon nanocrystal and having a number density of 1×10¹²/cm² or over, and
an electrode formed above said silicon nanocrystal via a silicon oxide layer,
wherein said silicon nanocrystal functions as a memory.

19. The floating gate type capacitor structure as defined in claim 18, wherein said silicon nanocrystal has a crystal grain size of 10nm or below.
